# EUROPEAN PATENT APPLICATION

(11) **EP 2 717 324 A1**
(43) Date of publication of application: **09.04.2014**
(21) Application number: 12792355.5
(22) Date of filing: 25.05.2012
(51) Int. Cl.: H01L 31/04

(54) **SOLAR CELL MODULE, METHOD FOR MANUFACTURING SOLAR CELL MODULE, AND TAB WIRE FOR THIN FILM SOLAR CELLS**

(30) Priority: 27.05.2011 JP 2011119686
(71) Applicant: Dexerials Corporation, Tokyo 141-0032 (JP)
(72) Inventor: NISHIMOTO, Masahiro, Tokyo 141-0032 (JP)
(74) Representative: Müller - Hoffmann & Partner
(86) International application number: PCT/JP2012/063543
(87) International publication number: WO 2012/165353

(57) **Abstract**

To ensure connection reliability between a tab wire for a collector and a tab wire for a terminal box over a long period of time. This solar cell module is provided with: a solar cell (1), on one surface of which an electrode (9) is arranged; and a tab wire (11), which includes a collector tab unit (12) that is connected onto the electrode (9) of the solar cell (1) with a connection layer (20) interposed therebetween and a terminal box tab unit (13) that is provided on one surface of the solar cell (1) with an insulating layer (21) interposed therebetween, and in this structure, the collector tab unit (12) and the terminal box tab unit (13) are continuously formed via a folded part (14).

## Description

### Field of the Invention

This invention relates to a solar cell module in which a positive electrode and a negative electrode are arranged on one of surfaces and a terminal box tab wire is installed thereon, and in particular concerns a solar cell module that can efficiently connect the positive electrode as well as negative electrode and the terminal box, and a method for manufacturing such a solar cell module.

The present application asserts priority rights based on JP Patent Application 2011-119686 filed in Japan on May 27, 2011. The total contents of disclosure of the Patent Application of the senior filing date are to be incorporated by reference into the present Application.

### Background of the Invention

In recent years, along with a trend in which a reduction in environmental load becomes a global subject, big expectations have been put on the photovoltaic power generation as a clean and reproducible energy. At present, the main trend for manufacturing solar cells concerns bulk silicon solar cells in which crystals of a single crystal silicon and polycrystal silicon are produced and these are slice-processed to form a plate-shaped semiconductor and this is utilized. In this case, however, the bulk silicon solar cell requires much energy and time so as to grow silicon crystals and complicated processes are also required for its manufacturing processes.

On the other hand, a so-called thin-film solar cell in which a semiconductor layer serving as a photoelectric conversion layer is formed on a substrate such as glass, stainless steel or the like is considered to form a main stream of the solar cells in the future, because of its thinness, light weight, inexpensive manufacturing costs, easiness of manufacturing a large surface area and the like. Examples of the thin-film solar cell include a thin-film silicon solar cell composed of amorphous silicon and a microcrystal silicon film or a tandem-type of these, and a CIGS-type solar cell or the like in which a compound semiconductor formed by mixing elements, typically represented by Cu (copper), In (indium), Ga (gallium) and Se (serene), is utilized.

These thin-film solar cells are formed through processes in which on an inexpensive substrate with a large area, a semiconductor layer or a metal electrode film is stacked by using a forming device, such as a plasma CVD device or a sputtering device, and thereafter, a photoelectric conversion layer formed on the same substrate is separated and connected by using a laser patterning process or the like so that solar cell strings are formed.

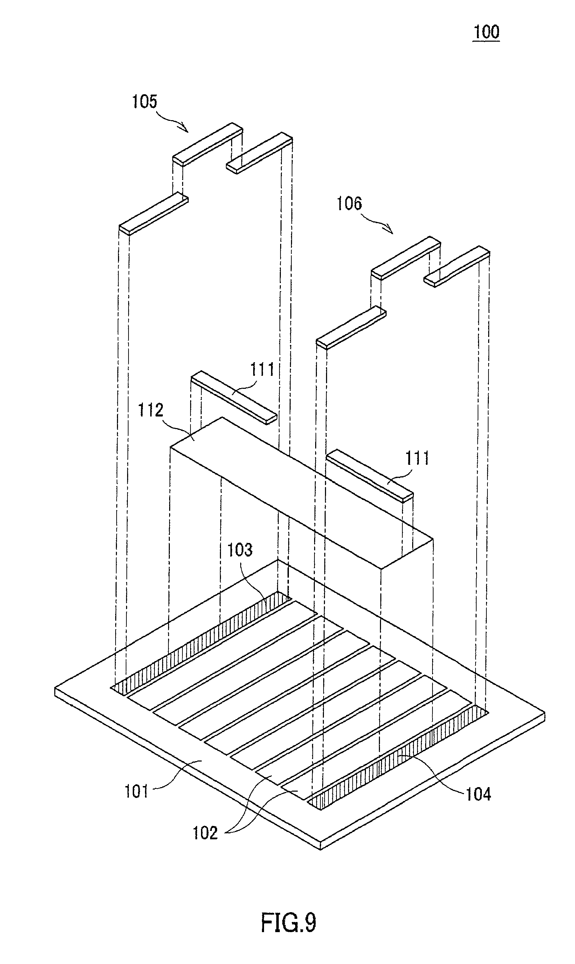

Fig. 9 shows one example of a configuration of a conventional thin-film solar cell in which the solar cell strings are used. This thin-film solar cell 100 is composed of a plurality of solar cells 102 each formed by stacking on a translucent insulating substrate 101 a transparent electrode film made of a transparent conductive film, not shown, a photoelectric conversion layer and a rear-surface electrode film. Each solar cell 102 has a thin elongated stripe-shape, and has a length that extends over the entire width of the translucent insulating substrate 101.

Moreover, the thin-film solar cell 100 is configured such that between mutually adjacent solar cells 102, by connecting a transparent electrode film on one side to a rear-surface electrode film on the other side so that the plural solar cells 102 are connected in series with one after another.

On an end portion of a transparent electrode film of the solar cell 102 of one end portion in the thin-film solar cell 100, a linear P-type electrode terminal unit 103 having virtually the same length as that of the solar cell 102 is formed, and on an end portion of a rear-surface electrode film of the solar cell 102 on the other end portion, a linear N-type electrode terminal unit 104 having virtually the same length as that of the solar cell 102 is formed. These P-type electrode terminal unit 103 and N-type electrode terminal unit 104 form electrode output units.

With respect to the P-type electrode terminal unit 103, a positive electrode collector tab wire 105 made of a copper foil and referred to as a bus bar is electrically and mechanically joined to the entire surface of the P-type electrode terminal unit 103. In the same manner, with respect to the N-type electrode terminal unit 104, a negative electrode collector tab wire 106 made of a copper foil is electrically and mechanically joined to the entire surface of the N-type electrode terminal unit 104. As the joining means for these, a soldering process, a conductive paste or the like may be used.

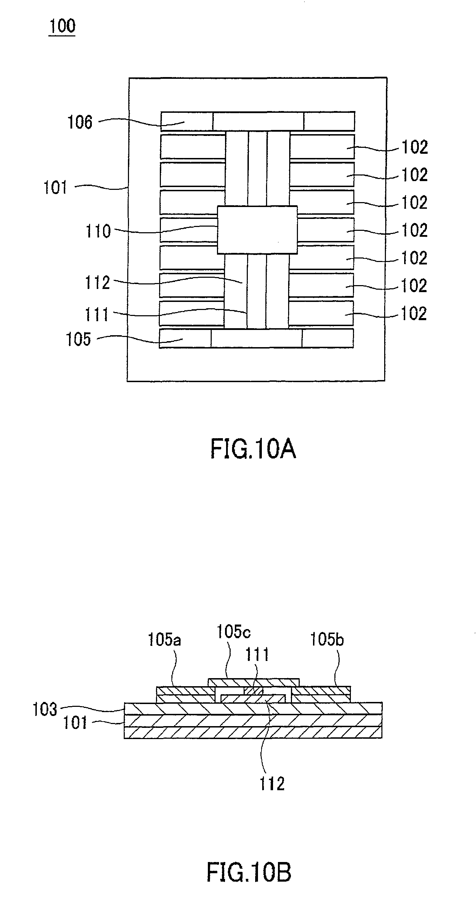

Moreover, as shown in Fig. 10A, onto the rear surface of the thin-film solar cell 100, a terminal box 110 that is connected to the P-type electrode terminal unit 103 and the N-type electrode terminal unit 104 so as to externally output electricity and a terminal box tab wire 111 for connecting this terminal box 110 to the P-type electrode terminal unit 103 and the N-type electrode terminal unit 104 are connected.

The terminal box 110 is secured in the center of the rear surface of the thin-film solar cell 100, for example, with an insulating adhesive being interposed therebetween. The terminal box tab wire 111 is made of an elongated copper foil or Al foil in the same manner as in the positive electrode collector tab wire 105 and the negative electrode collector tab wire 106, and disposed on the rear surface of the thin-film solar cell 100 with an insulating tape 112 interposed therebetween.

The terminal box tab wire 111 has its one end solder-connected to the terminal box 110, with the other end being disposed on the P-type electrode terminal unit 103 or the N-type electrode terminal unit 104 with the insulating tape 112 interposed therebetween.

As shown in Fig. 10B, the connection portion of the terminal box tab wire 111 and the positive electrode collector tab wire 105 is configured such that a third positive electrode collector tab wire 105c is connected along a gap between first and second positive electrode collector tab wires 105a and 105b connected to two sides sandwiching the insulating tape 112 and the terminal box tab wire 111, in a manner so as to bridge over the insulating tape 112 and the terminal box tab wire 111. Moreover, the third positive electrode collector tab wire 105c is connected to the terminal box tab wire 111. The connections (two portions) between these first and second positive electrode collector tab wires 105a, 105b and the third positive electrode collector tab wire 105c and the connection (one portion) between the third positive electrode collector tab wire 105c and the terminal box tab wire 111 are carried out by ultrasonic solder joining processes. The connection between the negative electrode collector tab wire 106 and the terminal box tab wire 111 is also carried out in the same manner.

### Prior-Art Documents

### Patent Document

PTL 1: Japanese Patent Application Laid-Open No. 2009-295744
PTL 2: Japanese Patent Application Laid-Open No. 2009-182066

### Summary of the Invention

However, in the case of using the ultrasonic solder connection, since the thin-film solar cell 100 is formed by using various materials, such as Al, Ag, ZnO or the like, depending on manufacturing methods and configurations of the P-type electrode terminal unit 103 and the N-type electrode terminal unit 104, the use of solder sometimes fails to maintain the connection strength to the positive electrode collector tab wire 105 and the negative electrode collector tab wire 106 depending on materials. For this reason, a joining medium, such as laser scribe and an Ag paste, is required. Since a portion subjected to a laser scribing treatment fails to devote to power generation, causing degradation in power generating efficiency.

Moreover, upon connection between the first and second positive electrode tab wires 105a, 105b and the third positive electrode collector tab wire 105c as well as upon connection between the third positive electrode collector tab wire 105c and the terminal box tab wire 111, since a heat history in a high temperature range caused by the soldering connection is locally applied, the translucent insulating substrate 101 made of glass or the like tends to have warping, or is sometimes damaged.

Moreover, in the thin-film solar cell 100 shown in Fig. 10, a charge is concentrated on the connection portion between the positive electrode collector tab wire 105 as well as the negative electrode collector tab wire 106 and the terminal box tab wire 111, resulting in a problem of a reduction in the power generation efficiency due to an increase of the resistance value.

Therefore, the object of the present invention is to provide a solar cell that ensures connection reliability between the positive electrode collector tab wire as well as the negative electrode collector tab wire and the terminal box tab wire for a long period of time, a method for manufacturing such a solar cell, and a tab wire for a thin-film solar cell.

In order to solve the above-mentioned problems, a solar cell in accordance with the present invention is provided with a solar cell with an electrode disposed on one surface thereof; a collector tab unit connected onto the electrode of the solar cell with a connection layer interposed therebetween; a terminal box tab unit formed on one of surfaces of the solar cell with an insulating layer interposed therebetween; and a tab wire in which the collector tab unit and the terminal box tab unit are continuously formed through a folded part.

Moreover, a method for manufacturing a solar cell in accordance with the present invention includes the steps of: preparing a tab wire having a collector tab unit connected to an electrode of a solar cell and a terminal box tab unit formed on one surface on the solar cell; connecting the collector tab unit to the electrode formed on the one surface of the solar cell, with a connection layer being interposed therebetween; forming the terminal box tab unit on the one surface of the solar cell by folding the portion thereof at the collector tab unit with an insulating layer interposed therebetween; and connecting one end of the terminal box tab unit to a terminal box.

Furthermore, a tab wire for a thin-film solar cell in accordance with the present invention is provided with: a collector tab unit connected onto an electrode of a solar cell with a connection layer interposed therebetween, the electrode being disposed on one surface of the solar cell; and a terminal box tab unit formed on the one surface of the solar cell with an insulating layer interposed therebetween, and in this structure, the collector tab unit and the terminal box tab unit are continuously formed through a folded part.

### Effects of Invention

In accordance with the present invention, since the tab wire is designed such that its collector tab unit and terminal box tab unit are continuously formed through a folded part without using a joining portion, it is possible to prevent an increase of a resistance value caused by a concentrated charge onto the joining portion, degradation of connection reliability of the joining portion, and damages or the like to a substrate due to concentrated heat and stress onto the joining portion, etc.

### Brief Description of Drawings

Figures 1A and 1B are plan views showing a solar cell to which the present invention is applied; and Figure 1A shows a state before a connection of a tab wire, and Figure 1B shows a state prior to a bending process of the connected tab wire.
Figure 2 is an exploded perspective view showing a solar cell module.
Figure 3 is a plan view showing the solar cell to which the present invention is applied.
Figure 4 is a cross-sectional view showing a tab wire to which the present invention is applied.
Figure 5 is a cross-sectional view showing a configuration of a conductive adhesion film.
Figure 6 is a view showing the conductive adhesion film.
Figure 7 is a cross-sectional view showing a state in which a tab wire, which has concavo-convex portions, with peak portions and bottom portions that continuously extend in the longitudinal direction over a surface being alternately formed in the width direction, is connected to an electrode.
Figures 8A and 8B are views showing a modified example of the present invention; and Figure 8A shows a state prior to a bending process of a tab wire, and Figure 8B shows a state after the bending process of the tab wire.
Figure 9 is an exploded perspective view showing one example of a conventional thin-film solar cell.
Figures 10A and 10B are views showing an example of a conventional thin-film solar cell; and Figure 10A is a plan view and Figure 10B is a cross-sectional view showing an electrode terminal unit.

### Detailed Description of the Invention

Referring to Figures, the following description will discuss a solar cell to which the present invention is applied and a method for manufacturing the solar cell in detail. Additionally, the present invention is not intended to be limited only by the following embodiments, and it is needless to say that various modifications may be made within the scope not departing from the gist of the invention.

### [Solar Cell Module]

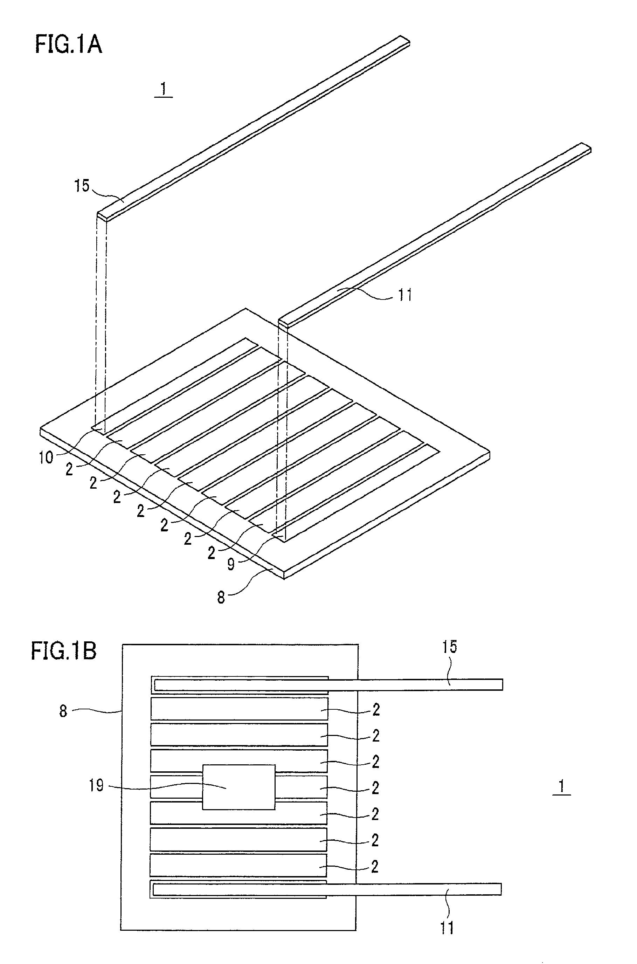

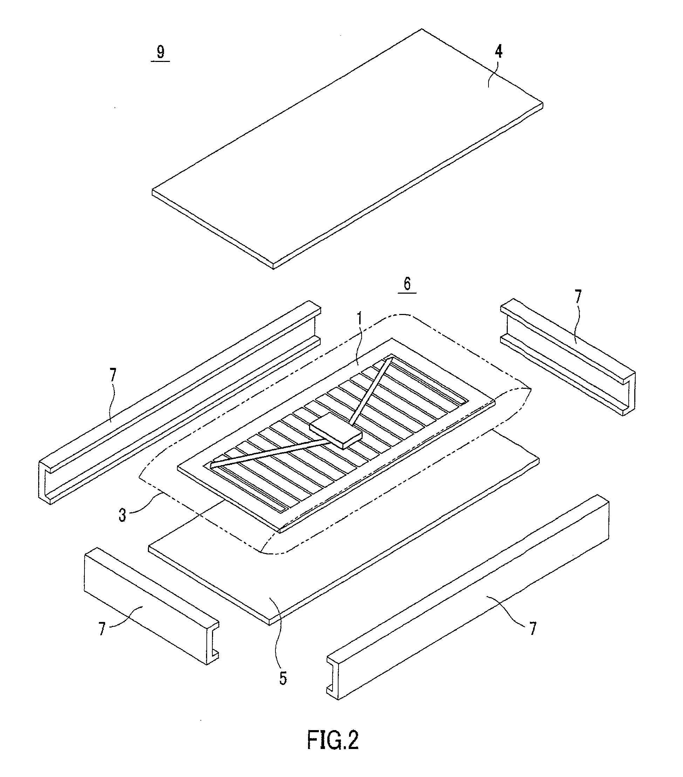

As shown in Figs. 1A and 1B, a thin-film solar cell 1 to which the present invention is applied is constituted by solar cell strings in which a plurality of solar cells 2 are connected to one after another by contact lines. As shown in Fig. 2, the thin-film solar cell 1 having this string structure is sandwiched by sheets 3 of a sealing adhesive, as a single unit or as a matrix in which a plurality of sheets thereof are connected with one another, and laminated together with a surface cover 5 formed on a light-receiving surface side and a back sheet 4 formed on a rear surface side as one lot so that a solar cell module 6 is formed. Additionally, a metal frame 7 made of aluminum or the like is attached to the peripheral portion of the solar cell module 6 on demand.

As the sealing adhesive, for example, a translucent sealing material, such as an ethylene vinyl acetate resin (EVA) or the like, is used. As the surface cover 5, for example, a translucent material, such as glass or a translucent plastic material, is used. As the back sheet 4, a laminate member or the like in which glass or an aluminum foil is sandwiched by resin films is used.

### [Solar Cell]

The thin-film solar cell 1 to which the present invention is applied is a solar cell of a super straight type which is composed of a transparent electrode film made of a transparent conductive film, a photoelectric conversion layer and a rear surface electrode film that are stacked on a translucent insulating substrate 8 in this order, although illustrations thereof are omitted from the Figures, with light being made incident thereon from the translucent insulating substrate 8 side. Additionally, as the thin-film solar cell, a solar cell of a sub-straight type in which a substrate member, a rear surface electrode, a photoelectric conversion layer and a transparent electrode are stacked in this order may be used. The following description will be given by exemplifying the thin-film solar cell 1 of the super straight type; however, the present technique may be applied to a thin-film solar cell of the sub-straight type.

As the translucent insulating substrate 8, glass and a heat resistant resin such as polyimide may be used.

As the transparent electrode film, for example, SnO₂, ZnO, ITO or the like may be used. As the photoelectric conversion layer, a silicon-based photoelectric conversion film, such as amorphous silicon, microcrystal silicon or polycrystal silicon, and a compound-based photoelectric conversion film, such as CdTe, CuInSe₂, Cu(In, Ga)Se₂ or the like, may be used.

As the rear surface electrode film, for example, a laminate structure of a transparent conductive film and a metal film may be used. The transparent electrode film may be made of SnO₂, ZnO, ITO or the like. The metal film may be made of silver, aluminum or the like.

As shown in Fig. 1A, the thin-film solar cell 1 configured in this manner has a structure in which a plurality of solar cells 2 having a rectangular shape with a length covering virtually the entire width of the translucent insulating substrate 8 are formed thereon. The respective solar cells 2 are separated from each other by electrode dividing lines, and between adjacent solar cells 2, the transparent electrode film on one side and the rear surface electrode film on the other side are connected to each other by a contact line so that a solar cell string in which the plural solar cells 2 are connected in series with one after another is formed.

Moreover, in the thin-film solar cell 1, on an end of the transparent electrode film of the solar cell 2 on one end portion of the solar cell string, a linear P-type electrode terminal unit 9 that has virtually the same length as that of the solar cell 2 is formed, and on an end of the rear surface electrode film of the solar cell 2 on the other end portion, a linear N-type electrode terminal unit 10 that has virtually the same length as that of the solar cell 2 is formed. In the thin-film solar cell 1, these P-type electrode terminal unit 9 and N-type electrode terminal unit 10 form electrode output units so that electricity is supplied to a terminal box 19 through a positive electrode tab wire 11 and a negative electrode tab wire 15.

### [Tab Wire]

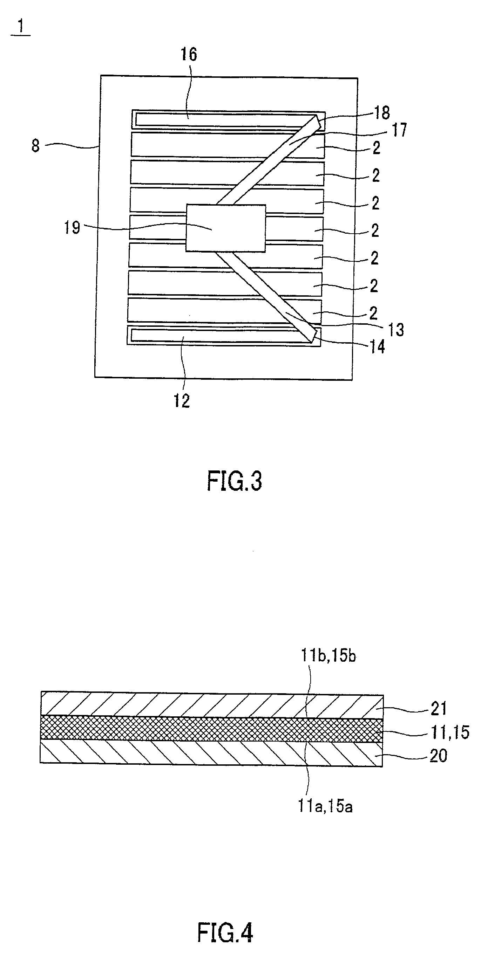

As shown in Fig. 3, the positive electrode tab wire 11 is provided with a positive electrode collector tab unit 12 connected onto the P-type electrode terminal unit 9 of the thin-film solar cell 1 through a connection layer 20 and a terminal box positive electrode tab unit 13 formed on the rear surface electrode film of the thin-film solar cell 1 with an insulating layer 21 interposed therebetween, and the positive electrode collector tab unit 12 and the terminal box positive electrode tab unit 13 are continuously formed through a folded part 14.

The negative electrode tab wire 15 is provided with a negative electrode collector tab unit 16 connected onto the N-type electrode terminal unit 10 of the thin-film solar cell 1 through the connection layer 20 and a terminal box negative electrode tab unit 17 formed on the rear surface electrode film of the thin-film solar cell 1 with the insulating layer 21 interposed therebetween, and the negative electrode collector tab unit 16 and the terminal box negative electrode tab unit 17 are continuously formed through a folded part 18.

The following description will explain the positive electrode tab wire 11 in detail; however, the negative electrode tab wire 15 also has the same configuration as that of the positive electrode tab wire 11.

The positive electrode tab wire 11 is formed by processes in which a copper foil or an aluminum foil that has been subjected to a rolling process into a thickness of 50 to 300µm is slit, or a thin metal wire of copper or aluminum is subjected to a rolling process into a flat plate shape so that it is prepared as a flat rectangular-shaped copper wire having a width of 1 to 3 mm that is virtually the same width as that of the P-type electrode terminal unit 9.

The positive electrode collector tab unit 12 is configured such that one of the surfaces of the positive electrode tab wire 11 is electrically as well as mechanically joined to the entire surface of the P-type electrode terminal unit 9 through the connection layer 20. Moreover, the terminal box positive electrode tab unit 13 corresponds to a tip portion of one portion of the positive electrode tab wire 11 folded as the folded part 14, with the other surface of the positive electrode tab wire 11 being formed on the rear surface electrode film of the thin-film solar cell 1 with the insulating layer 21 interposed therebetween. The terminal box positive electrode tab unit 13 is prevented from short-circuiting by the insulating layer 21 even when made in contact with the rear surface electrode film of the thin-film solar cell 1. Moreover, the terminal box positive electrode tab unit 13 has its tip end connected to a terminal mount of the terminal box 19.

The folded part 14 is formed on one portion of the positive electrode tab wire 11, for example, on the end portion of the positive electrode collector tab unit 12. The positive electrode tab wire 11 is configured such that its tip extended from the folded part 14 is formed into the terminal box positive electrode tab unit 13. Therefore, in the positive electrode tab wire 11, since the positive electrode collector tab unit 12 and the terminal box positive electrode tab unit 13 are continuously joined to each other through the folded part 14, with no connecting portion being prepared, it is possible to prevent an increase of a resistance value caused by a concentrated charge onto the joining portion, degradation of connection reliability of the joining portion, damages or the like to the translucent insulating substrate 8 due to concentrated heat and stress onto the joining portion, etc.

### [Connection Layer]

As shown in Fig. 4, in each of the positive electrode tab 11 and the negative electrode tab 15, a connection layer 20 is formed on one of the surfaces 11a or 15a thereof so as to be connected to the P-type electrode terminal unit 9 or the N-type electrode terminal unit 10. The connection layer 20 is formed at least on one of the surfaces 11a or 15a, preferably on one of the entire surfaces of 11a or 15a, of the positive electrode collector tab unit 12 and the negative electrode collector tab unit 16 of the positive electrode tab wire 11 and the negative electrode tab wire 15, and composed of, for example, a coating solder or a conductive adhesion film 22.

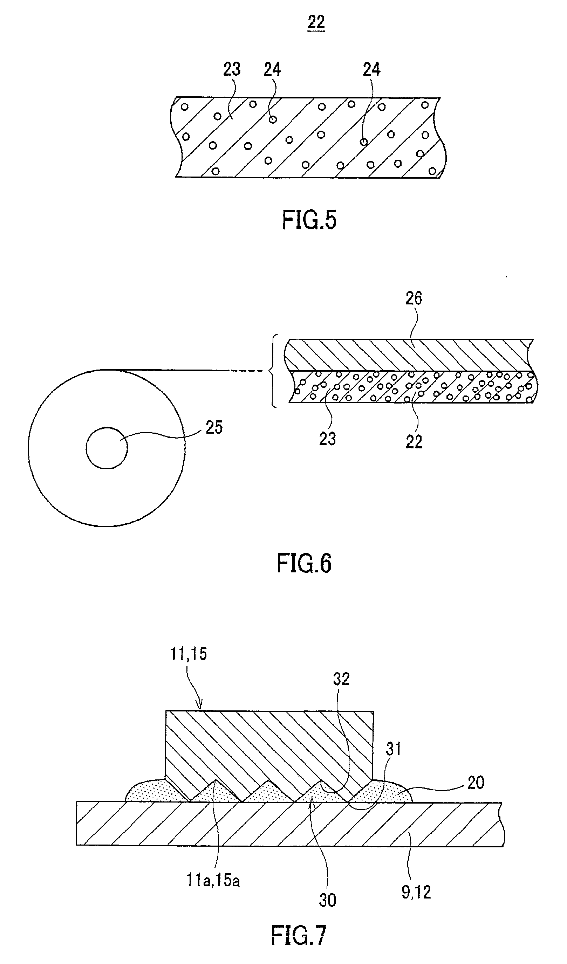

As shown in Fig. 5, the conductive adhesion film 22 is composed of conductive particles 24 contained in a thermosetting binder resin layer 23 at high density. Moreover, from the viewpoint of indenting property, the conductive adhesion film 22 is preferably set to have the lowest melt viscosity of the binder resin in a range from 100 to 100000 Pa•s. When the lowest melt viscosity of the conductive adhesion film 22 is too low, the resin tends to flow from a low press-bonding process to a main curing process to easily cause any connection failure or any protrusion onto the cell light receiving surface, resulting in a reduction in light receiving rate. Moreover, when the lowest melt viscosity is too high, a failure tends to occur upon pasting the film, resulting in any adverse effect to connection reliability. Additionally, the lowest melt viscosity can be measured by loading a predetermined amount of a sample to a rotary viscometer and measuring the viscosity while raising the temperature at a predetermined rate.

Although not particularly limited, as the conductive particles 24 used for the conductive adhesion film 22, examples thereof include: metal particles such as nickel, gold, silver and copper, resin particles that are subjected to gold plating or the like, and those resin particles that are subjected to gold plating, with their outermost layer being coated with an insulating material.

The conductive particles may be powder, with the respective pieces of powder individually located one by one; however, those particles with primary particles coupled to one after another into a chain shape are preferably used. Examples of the former include spherical nickel powder with spike-shaped protrusions thereon, and examples of the latter, which are preferably used, include filament-shaped nickel powder. By using the latter, the elasticity of the conductive particles 24 is improved, and the connection reliability between the positive electrode tab wire 11 and the P-type electrode terminal unit 9, as well as the connection reliability between the negative electrode tab wire 15 and the N-type electrode terminal unit 10, having respectively different physical properties, can be improved respectively.

Moreover, the conductive adhesion film 22 preferably has a viscosity in a range from 10 to 10000 kPa•s, and more preferably, from 10 to 5000 kPa•s, at about normal temperature. By setting the viscosity of the conductive adhesion film 22 in the range from 10 to 10000 kPa•s, it becomes possible to prevent blocking due to so-called protrusion at the time when the conductive adhesion film 22 is formed on one surface 11a or 15a of the positive electrode tab wire 11 or the negative electrode tab wire 15, and is wound into a reel 25, and also to maintain a predetermined tacking strength.

Although not particularly limited as long as the above-mentioned characteristics are not impaired, the composition of the binder resin layer 23 of the conductive adhesion film 22 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., the phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as a hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, any of these may be used. Among these, in the present invention, the potential curing agent of a hot setting-type is preferably used, and the curing agent is subjected to a main curing process by being heated and pressed onto the busbar electrodes 11 and the rear-surface electrode 13. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present embodiment, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

Fig. 6 is a schematic view that shows one example of a product mode of the conductive adhesion film 22. The conductive adhesion film 22 is provided with a peeling base member 26 with a binder resin layer 23 laminated thereon, and these are molded into a tape shape. This tape-shaped conductive adhesion film 22 is wound around and stacked on a reel 25, with the peeling base member 26 being located on the peripheral side. As the peeling base member 26, not particularly limited, PET (Poly Ethylene Terephthalate), OPP (Oriented Polypropylene), PMP (Poly-4-methylpentene-1), PTFE (Polytetrafluoroethylene) and the like may be used.

The conductive adhesion film 22 has a structure in which the aforementioned positive electrode tab wire 11 or the negative electrode tab wire 15 is adhered onto the binder resin layer 23 as a cover film. That is, the conductive adhesion film 22 is formed by stacking the binder resin layer 23 on one surface 11a or 15a of the positive electrode tab wire 11 or the negative electrode tab wire 15. In this manner, by preliminarily laminating the positive electrode tab wire 11 or the negative electrode tab wire 15 together with the conductive adhesion film 22 into an integral laminate, the peeling base member 26 can be separated at the time of an actual application, and by pasting the binder resin layer 23 of the conductive adhesion film 22 onto the P-type electrode terminal unit 9 or the N-type electrode terminal unit 10 so that the positive electrode tab wire 11 or the negative electrode tab wire 15 is temporarily pasted onto the electrode terminal unit 11 or 12.

The above-mentioned conductive adhesion film 22 is produced by dissolving conductive particles 24, a film-forming resin, a liquid-state epoxy resin, a potential curing agent and a silane coupling agent in a solvent. As the solvent, toluene, ethyl acetate, or the like, or a mixed solvent of these, may be used. The resin forming solution obtained by the dissolving process is applied onto the peeling base member 26, and the solvent is volatilized so that the conductive adhesion film 22 is obtained. Thereafter, the conductive adhesion film 22 is pasted onto one of the surfaces 11a or 15a of the positive electrode tab wire 11 or the negative electrode tab wire 15. Thus, the conductive adhesion film 22 is formed over the entire portion of one of the surfaces 11a or 15a of the positive electrode tab wire 11 or the negative electrode tab wire 15.

When the positive electrode tab wire 11 or the negative tab wire 15 is temporarily pasted onto the P-type electrode terminal unit 9 or the N-type electrode terminal unit 12, this conductive adhesion film 22 is heated and pressed at predetermined temperature and pressure by a hot pressing head or a vacuum laminator. Thus, the conductive adhesion film 22 is designed such that its binder resin is allowed to flow out between the P-type electrode terminal unit 9 and the positive electrode collector tab unit 12 as well as between the N-type electrode terminal unit 10 and the negative collector tab unit 16, with the conductive particles 24 being sandwiched between the respective collector tab units 12, 16 and the respective electrode terminal units 9, 10, and in this state, the binder resin is cured. Thus, the conductive adhesion film 22 is adhered onto each of the collector tab units 12, 16 and the electrode terminal units 9, 10, with the respective collector tab units 12, 16 and the respective electrode terminal units 9, 10 being conducted and connected to each other.

Additionally, the connection between the P-type electrode terminal unit 9 and the positive electrode tab wire 11, as well as the connection between the N-type electrode terminal unit 10 and the negative electrode tab wire 15, may be carried out by using an insulating adhesive, such as an insulating adhesive film, an insulating adhesive paste, or the like, in addition to the above-mentioned conductive adhesion film 22. The insulating adhesive film has the same configuration as that of the conductive adhesion film except that no conductive particles are included in the binder resin layer.

### [Concavo-convex Portions]

In the case when the insulating adhesive is used as a connection layer, each of the positive electrode tab wire 11 and the negative electrode tab wire 15 is provided with concavo-convex portions 30 formed on one of the surfaces 11a and 15a to be connected to the P-type electrode terminal unit 9 and the N-type electrode terminal unit 10. The concavo-convex portions 30 are composed of concave portions and convex portions that are regularly or irregularly formed on the entire surface of one of the surfaces 11a and 15a of the positive electrode tab wire 11 and the negative electrode tab wire 15, and formed by a press molding process of a ribbon-shaped copper foil, an etching process carried out on one of the surfaces 11a and 15a, or the like.

For example, as shown in Fig. 7, in the positive electrode tab wire 11 and the negative electrode tab wire 15, a plurality of convex portions 31 and concave portions 32, which are continuously extended in the longitudinal direction of one of the surfaces 11a and 15a, are alternately formed in the width direction so that the concavo-convex portions 30 are formed. Thus, even in the case of using the insulating adhesive as the connection layer 20, the positive electrode tab wire 11 or the negative electrode tab wire 15 is made conductive, with the convex portions 31 of the concavo-convex portion 30 being directly made in contact with the P-type electrode terminal unit 9 or the N-type electrode terminal unit 12.

In addition to the use of the insulating adhesive, even in the case of using a conductive adhesive or solder, concavo-convex portions 30 may be formed on one of the surfaces 11a and 15a in the positive electrode tab wire 11 and the negative electrode tab wire 15.

### [Modified Example]

Moreover, the connection layer 20 may not necessarily be stacked preliminarily on one of the surfaces 11a and 15a of the positive electrode tab wire 11 and the negative electrode tab wire 15. In this case, in addition to film-shaped materials, such as the conductive adhesion film and the insulating adhesive film, paste-state materials, such as a conductive adhesion paste and an insulating adhesive paste, or solder may be used to form the connection layer 20.

In the present embodiment, the film-shaped conductive adhesion film 22, the paste-state conductive adhesive paste, or solder, which contains the conductive particles 24, is defined as "conductive adhesive", while the film-state insulating adhesive film or the insulating adhesive paste, which contains no conductive particles, is defined as "insulating adhesive".

In the case of joining the conductive adhesion film 22 or the insulating adhesive film to the positive electrode tab wire 11 or the like, this connection layer 20 is cut into a predetermined length in accordance with the P-type electrode terminal unit 9 or the N-type electrode terminal unit 10, and is temporarily pasted onto the P-type electrode terminal unit 9 and onto the N-type electrode terminal unit 10 of the thin-film solar cell 1. Alternatively, as the connection layer 20, a conductive adhesive paste, an insulating adhesive paste, solder or the like is applied onto the P-type electrode terminal unit 9 and onto the N-type electrode terminal unit 10. Next, the positive tab wire 11 and the negative tab wire 15, cut into predetermined lengths, are superposed and disposed on the connection layer 20, and subjected to heating and pressing processes so as to be made conductive and connected thereto.

### [Insulating Layer]

As shown in Fig. 4, in each of the positive electrode tab 11 and the negative electrode tab 15, an insulating layer 21 is formed on the other surface 11b or 15b thereof so as to be insulated from a rear surface electrode film of the thin-film solar cell 1. The insulating layer 21 is formed on the other surface 11b or 15b of at least the terminal box positive tab unit 13 and the terminal box negative tab unit 17 of the positive electrode tab wire 11 and the negative electrode tab wire 15, preferably on the other entire surface 11b or 15b, and composed of, for example, an insulating film with an adhesive.

The insulating film with an adhesive is formed by placing an adhesive layer on one of the surfaces of an insulating film made of PET, PI or the like. As the adhesive layer, an epoxy-based adhesive or the like, such as the aforementioned insulating adhesive film, may be used.

When formed at least on the terminal box positive electrode tab unit 13 and the terminal box negative electrode tab unit 17, the insulating layer 21 is made face to face with the rear surface of the thin-film solar cell 1, with the positive electrode tab wire 11 or the negative electrode tab wire 15 being folded. Therefore, the insulating layer 21 makes it possible to prevent the terminal box positive tab unit 13 and the terminal box negative electrode tab unit 17 from causing short circuits with the rear surface electrode film of the thin-film solar cell 1.

In other words, by interpolating the insulating layer 21 between the positive electrode tab wire 11 as well as the negative electrode tab wire 15 and the rear surface electrode film, the thin-film solar cell 1 makes it possible to eliminate the insulating film for insulating between the terminal box tab wire and the rear surface electrode film of the thin-film solar cell, which has been conventionally required. Moreover, since it has been preliminarily formed on the terminal box positive electrode tab unit 13 and the terminal box negative electrode tab unit 17, the insulating film can be formed with the minimum area required, so that it is not necessary to prepare an insulating film with a large area, which has been conventionally required.

Moreover, the insulating layer 21 is preferably stacked on the other surface 11b, 15b of the positive electrode tab wire 11 or the negative electrode tab wire 15, with an adhesive layer being interposed therebetween, so that it is formed on the entire surface of the other surface 11b, 15b. With this configuration, the insulating layer 21 appears outward from the rear surface of the thin-film solar cell 1 on the positive electrode collector tab unit 12 and on the negative electrode collector tab unit 16. Thus, in the thin-film solar cell 1, even when sealed with a translucent sealing resin such as an ethylene vinyl acetate resin (EVA) or the like, the positive electrode tab wire 11 and the negative electrode tab wire 15, which are coated with the insulating layer 21, are prevented from reacting with the translucent sealing resin to be corroded.

Moreover, by using a colored insulating film as the insulating layer 21, it becomes possible to improve the designing property of the invention.

Additionally, as the insulating layer 21, in addition to the insulating film with an adhesive, a heat resistant paint may be used. As this heat resistant paint, for example, a silicon resin-based heat resistant paint is proposed, and as a commercially available product, acid resistant Thermo made by Kansai Paint Co., Ltd. can be exemplified. By forming the insulating layer using the heat resistant paint, the positive electrode tab wire 11 and the negative electrode tab wire 15 can be made thinner in comparison with the use of the insulating film with an adhesive.

### [Excessive Portion]

As shown in Fig. 3, in the positive electrode tab wire 11, the positive electrode conductor tab unit 12 has virtually the same length as that of the P-type electrode terminal 9, and an excessive portion, which is protruded from the upper portion of the P-type electrode terminal unit 9 and located on a tip side from the folded section 14, is formed as the terminal box positive electrode tab unit 13. Moreover, the positive electrode tab wire 11 has its terminal box positive electrode tab unit 13 folded onto the rear surface electrode film of the thin-film solar cell 1, with its tip end being connected with the terminal box 19. The negative electrode tab wire 15 also has the same configuration.

The positive electrode tab wire 11 preferably has a length virtually about two times the length of the P-type electrode terminal unit 9, and is desirably folded at a position of virtually 50% of the entire length. With this configuration, regardless of the position of the terminal box 19 on the rear surface electrode film of the thin-film solar cell 1, the positive electrode tab wire 11 positively allows the terminal box positive electrode tab unit 13 to be connected to the terminal box 19. The negative electrode tab wire 15 also has the same configuration.

### [Modified Example]

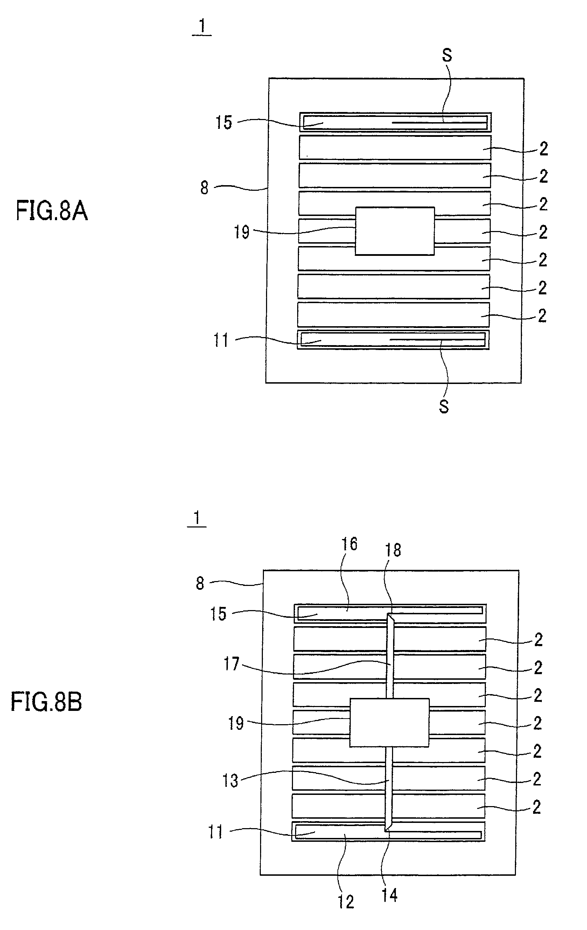

As shown in Figs. 8A and 8B, the thin-film solar cell 1 may be configured such that a slit S that extends in the longitudinal direction is formed virtually in the middle portion in the width direction of the positive electrode tab wire 11 or the negative electrode tab wire 15, with folded sections 14 and 18 being formed on one of portions divided by the slit S, and with the tips of the folded sections 14 and 18 serving as the terminal box positive electrode tab unit 13 or the terminal box negative electrode tab unit 17. In this case, the other portion divided by the slit constitutes the positive electrode collector tab unit 12 or the negative electrode collector tab unit 16 together with the portion with no slit S formed therein. Moreover, the positive electrode tab wire 11 and negative electrode tab wire 15 may not necessarily be made longer than the P-type electrode terminal unit 9 and the N-type electrode terminal 10. The length of the slit S is determined on demand depending on the distance to the terminal box 19.

### [Terminal Box]

Moreover, on the rear surface electrode film of the thin-film solar cell 1, the terminal box 19, which electrically connects with the terminal box positive electrode tab unit 13 and the terminal box negative electrode tab unit 17 of the positive electrode tab wire 11 and the negative electrode tab wire 15, is formed. The terminal box 19 has its external output wire electrically connected thereto so that power collected by the positive electrode tab wire 11 and the negative electrode tab wire 15 is supplied externally.

The terminal box 19 is secured onto the rear surface electrode film of the thin-film solar cell 1 via the insulating adhesive film the detailed explanation of which will be omitted. The insulating adhesive film is composed of, virtually the same components as those of the aforementioned conductive adhesion film 22 except that no conductive particles are contained therein, and allows the terminal box 19 to be secured onto the rear surface electrode film of the thin-film solar cell 1 when the binder resin layer is thermally cured. Additionally, by mixing a chemically stable fluorine-based resin with the insulating adhesive film, even when temporarily pasted onto the rear surface electrode film of the thin-film solar cell 1, the insulating adhesive film is prevented from reacting with the rear surface electrode film to be corroded.

In this case, by placing the terminal box 19 at a position along the virtually middle portion in the width direction orthogonal to the longitudinal direction of the positive electrode tab wire 11 and the negative electrode tab wire 15 on the rear surface electrode film of the thin-film solar cell 1, the tab wires having the same size may be used as both of the positive electrode tab wire 11 and the negative electrode tab wire 15. Moreover, the position of the terminal box 19 may be exposed to the outside of the back sheet 4. In this case, the positive electrode tab wire 11 and the negative electrode tab wire 15 are allowed to penetrate the back sheet 4 at the folded part 14 and the folded part 18 so that the terminal box positive electrode tab unit 13 and the terminal box negative electrode tab unit 17 are connected to terminal units of the terminal box 19 formed on the outside of the back sheet 4.

### [Production Method]

Next, the following description will discuss processes in which the positive electrode tab wire 11 and the negative electrode tab wire 15 are connected to the thin-film solar cell 1. First, connection layers 20 are formed on the P-type electrode terminal unit 9 and the N-type electrode terminal unit 10 of the thin-film solar cell 1, and the positive electrode collector tab unit 12 or the negative electrode collector tab unit 16 is disposed thereon via the connection layer 20.

This process is carried out by disposing the positive electrode tab wire 11 or the negative electrode tab wire 15 on one of surfaces 11a or 15a of which a conductive adhesion film 22 or an insulating adhesive film has been preliminarily formed, or a solder coating process has been carried out, on the P-type electrode terminal unit 9 and the N-type electrode terminal unit 10. Alternatively, after forming a connection layer 20 by placing or applying a conductive adhesive or an insulating adhesive on the P-type electrode terminal unit 9 and the N-type electrode terminal unit 10, the positive electrode collector tab unit 12 of the positive electrode tab wire 11 or the negative electrode collector tab unit 16 of the negative electrode tab wire 15 is disposed on the connection layer 20.

Thereafter, the positive electrode tab wire 11 and the negative electrode tab wire 15 are heated and pressed at predetermined temperature and pressure for a predetermined period of time by a hot pressing head. Thus, in the connection layer 20, the binder resin of the conductive adhesive is allowed to flow out between the P-type electrode terminal unit 9 and the positive electrode collector tab unit 12 as well as between the N-type electrode terminal unit 10 and the negative electrode collector tab unit 16, with the conductive particles 24 being sandwiched between the respective collector tab units 12, 16 and the respective electrode terminal units 9, 10, so that the binder resin is cured in this state. Thus, the connection layer 20 allows the respective collector tab units 12, 16 to be adhered onto the respective electrode terminal units 9, 10, and also allows the respective collector tab units 12, 16 and the respective electrode terminal units 9, 10 to be conductively connected to each other. In the case when an insulating adhesive or solder is used as the connection layer 20 also, by carrying out the heating and pressing processes in the same manner, the respective collector tab units 12, 16 and the respective electrode terminal units 9, 10 are connected to each other.

Next, in each of the positive electrode tab wire 11 and the negative electrode tab wire 15, an excessive portion located on the tip side from the P-type electrode terminal unit 9 or the N-type electrode terminal unit 10 is folded onto the rear surface electrode of the thin-film solar cell 1 so as to form each of the folded parts 14 and 18, and the terminal box positive electrode tab unit 13 and the terminal box negative electrode tab unit 17 are disposed on the rear surface electrode film, with the insulating layer 21 interposed therebetween.

At the tip end of each of the terminal box positive electrode tab unit 13 and the terminal box negative electrode tab unit 17, the conductive adhesive or the insulating adhesive forming the connection layer 20 and the insulating film with an adhesive or the heat resistant paint forming the insulating layer 21 is separated by separating the insulating film by utilizing a blade and heat so as to be made conductive. Thereafter, each of the positive electrode tab wire 11 and the negative electrode tab wire 15 has its tip end connected to the terminal base of the terminal box 19.

By carrying out these connection processes, a laser scribing process and an Ag paste application, which have been required for a conventional ultrasonic joining process, are no longer required so that the power generation area can be expanded and the power generation efficiency can be improved. Moreover, in comparison with the configuration in which the collector tab wire and the terminal box tab wire are joined to each other by using a conductive adhesion film, superior connection reliability is obtained for a long period of time, and since no connection between the collector tab wire and the terminal box tab wire is required, the connection resistance is lowered so that the power generation efficiency can be improved. Furthermore, in the positive electrode tab wire 11 and the negative electrode tab wire 15, since the insulating layer 21 is formed over the entire surface of each of the other surfaces 11b and 15b, the copper foil surface can be prevented from being oxidized.

In the positive electrode tab wire 11 and the negative electrode tab wire 15, in addition to the press-bonding process by using the hot pressing head, the respective collector tab units 12 and 16 and the respective electrode terminal units 9 and 10 may be connected respectively by carrying out a laminate press-bonding process as one lot together with the aforementioned sheet 3 of the sealing conductive, by using a laminator. In this case, in the positive electrode tab wire 11 and the negative electrode tab wire 15, the respective collector tab units 12 and 16 are temporarily pasted onto the respective electrode terminal units 9 and 10 at such a temperature as not to thermally cure the connection layer 20, and the terminal box tab units 13 and 17 are folded. Thereafter, a sealing resin sheet, such as EVA or the like, is mounted, and this is laminated as one lot by a vacuum laminator so that the connection layer 20 is thermally cured in the positive electrode tab wire 11 and the negative electrode tab wire 15 so that the respective collector tab units 12, 16 and the respective electrode terminal units 9, 10 are connected respectively.

### Examples

Next, the following description will discuss examples of the thin-film solar cell 1 using the positive electrode tab wire 11 and the negative electrode tab wire 15, in comparison with a conventional thin-film solar cell and a thin-film solar cell in which a positive electrode tab wire and a negative electrode tab wire without an insulating layer 21 are used.g

In any one of samples, a copper foil ribbon having a thickness of 70µm was used as a base member of the tab wire, and a connection layer was formed on one of surfaces that was connected to an electrode terminal unit of the thin-film solar cell. Moreover, in examples 1 to 6 as well as comparative examples 1 and 2, an insulating layer was also formed on the other surface.

Moreover, in each of the samples, the same thin-film solar cell (with a photoelectric conversion layer made of amorphous silicon) was used and connections were made to the P-type electrode terminal unit and the N-type electrode terminal unit.

In samples relating to examples 2 to 6 and comparative examples 1 to 3 and 5 and 6, after tab wires had been mounted on the P-type electrode terminal unit and the N-type electrode terminal unit with a conductive adhesive ("product name DT100 series": made by Sony Chemical & Information Device Corporation) or an insulating adhesive ("product name DT100 series without conductive particles": made by Sony Chemical & Information Device Corporation) being interpolated therebetween, heating and pressing processes were carried out so as to be connected (heating temperature: 180°C, pressure: 2MPa, heating and pressing time: 15 seconds). In samples relating to example 1 and comparative example 3, after tab wires had been mounted on the P-type electrode terminal unit and the N-type electrode terminal unit with a connection layer formed by coating an Al (aluminum) connecting ultrasonic solder being interpolated therebetween, heating and pressing processes were carried out so as to be connected.

Next, each of the samples was connected to the terminal box formed on the rear surface of the thin-film solar cell. In each of the examples and comparative examples 4 to 6, an excessive portion protruded from the electrode terminal unit was folded, and the tip portion of the folded part was connected to the terminal box.

Thereafter, a back sheet containing a sealing resin (EVA) and an aluminum foil were stacked thereon and laminated so that a module was produced. Then, the respective modules were examined as to whether or not a thinness was achieved, and a connection resistivity at the time of carrying a current of 1A after a high temperature and high humidity test (85°C, 85%RH for 1000 hrs) was measured on each of the modules.

The tab wire in accordance with example 1 was formed so as to prepare a terminal box tab unit by folding an excessive portion thereof located at a tip side from the collector tab unit connected to the electrode terminal unit. The folded angle was 135°. Moreover, in the tab wire in accordance with example 1, one surface thereof was solder coated to form a connection layer, and an insulating layer was formed on the other surface by pasting thereon PET with an epoxy-based adhesive layer formed therein.

The tab wire in accordance with example 2 was formed so as to prepare a terminal box tab unit by folding an excessive portion thereof located at a tip side from the collector tab unit connected to the electrode terminal unit. The folded angle was 90°. Moreover, in the tab wire in accordance with example 2, by pasting a conductive adhesion film onto one surface thereof, a connection layer was formed, and an insulating layer was formed on the other surface by pasting thereon PET with an epoxy-based adhesive layer formed therein.

The tab wire in accordance with example 3 was formed so as to prepare a terminal box tab unit by folding an excessive portion thereof located at a tip side from the collector tab unit connected to the electrode terminal unit. The folded angle was 135°. Moreover, the tab wire in accordance with example 3 had the same connection layer and insulating layer as those of example 2 formed thereon.

The tab wire in accordance with example 4 was formed so as to prepare a terminal box tab unit by folding an excessive portion thereof located at a tip side from the collector tab unit connected to the electrode terminal unit. The folded angle was 180°. Moreover, the tab wire in accordance with example 4 had the same connection layer and insulating layer as those of example 2 formed thereon. In example 4, the positive electrode tab wire and the negative electrode tab wire were respectively folded by 180° so that the terminal box tab units were respectively connected to the positive electrode terminal box and the negative electrode terminal box.

The tab wire in accordance with example 5 was formed so as to prepare a terminal box tab unit by folding an excessive portion thereof located at a tip side from the collector tab unit connected to the electrode terminal unit. The folded angle was 135°. Moreover, in the tab wire in accordance with example 5, by pasting an insulating adhesive film onto one surface thereof, a connection layer was formed, and an insulating layer was formed on the other surface by pasting thereon PET with an epoxy-based adhesive layer formed therein.

The tab wire in accordance with example 6 was formed so as to prepare a terminal box tab unit by folding an excessive portion thereof located at a tip side from the collector tab unit connected to the electrode terminal unit. The folded angle was 135°. Moreover, in the tab wire in accordance with example 6, by pasting a conductive adhesion film onto one surface thereof, a connection layer was formed, and an insulating layer was formed on the other surface by applying a heat resistant paint (acid resistant Thermo: made by Kansai Paint Co., Ltd.) thereto.

In comparative example 1, a terminal box tab wire and a collector tab wire were superposed on an electrode terminal unit so as to be connected. Moreover, in the terminal box tab wire in accordance with comparative example 1, a conductive adhesion film was pasted onto one surface to be connected to the collector tab wire so that a connection layer was formed thereon, and an insulating layer was formed on the other surface made in contact with a rear surface electrode film, by pasting thereon PET in which an epoxy-based adhesive layer was formed.

In comparative example 2, a terminal box tab wire and a collector tab wire were superposed on an electrode terminal unit so as to be connected. Moreover, in the terminal box tab wire in accordance with comparative example 2, a conductive adhesion film was pasted onto one surface to be connected to the collector tab wire so that a connection layer was formed thereon, and an insulating layer was formed on the other surface made in contact with a rear surface electrode film, by applying thereto a heat resistant paint (acid resistant Thermo: made by Kansai Paint Co., Ltd.).

In comparative example 3, a terminal box tab wire and a collector tab wire were superposed on an electrode terminal unit so as to be connected. Moreover, in the terminal box tab wire in accordance with comparative example 3, a conductive adhesion film was pasted onto one surface to be connected to the collector tab wire so that a connection layer was formed thereon, and no insulating layer was formed on the other surface made in contact with a rear surface electrode film.

The tab wire in accordance with comparative example 4 was formed so as to prepare a terminal box tab unit by folding an excessive portion thereof located at a tip side from the collector tab unit connected to the electrode terminal unit. The folded angle was 135°. Moreover, in the terminal box tab wire in accordance with comparative example 4, one surface to be connected to the collector tab wire was solder coated so that a connection layer was formed thereon, and no insulating layer was formed on the other surface made in contact with a rear surface electrode film.

The tab wire in accordance with comparative example 5 was formed so as to prepare a terminal box tab unit by folding an excessive portion thereof located at a tip side from the collector tab unit connected to the electrode terminal unit. The folded angle was 135°. Moreover, in the terminal box tab wire in accordance with comparative example 4, a conductive adhesion film was pasted onto one surface to be connected to the collector tab wire so that a connection layer was formed thereon, and no insulating layer was formed on the other surface made in contact with a rear surface electrode film.

The tab wire in accordance with comparative example 6 was formed so as to prepare a terminal box tab unit by folding an excessive portion thereof located at a tip side from the collector tab unit connected to the electrode terminal unit. The folded angle was 135°. Moreover, in the terminal box tab wire in accordance with comparative example 4, an insulating adhesive film was pasted onto one surface to be connected to the collector tab wire so that a connection layer was formed thereon, and no insulating layer was formed on the other surface made in contact with a rear surface electrode film.

The respective modules in accordance with examples and comparative examples were examined as to whether or not a thinness was achieved, and a connection resistivity at the time of carrying a current of 1A after a high temperature and high humidity test (85°C, 85%RH for 1000 hrs) was measured on each of the modules by using a 4-terminal method in which a current terminal and a voltage terminal were respectively connected onto two tab wires, and the results thereof are shown in Table 1. Additionally, the evaluation indexes of the thinness of the modules are explained as follows:
○: A maximum value of a partial thickness of the electrode terminal unit was 0.25 mm or less.
× : A maximum value of a partial thickness of the electrode terminal unit was greater than 0.25 mm.

Moreover, the evaluation indexes of the connection resistivity are explained as follows:
○: Less than 12 Ω
Δ: 12 Ω or more to less than 18 Ω
×: 18 Ω or more

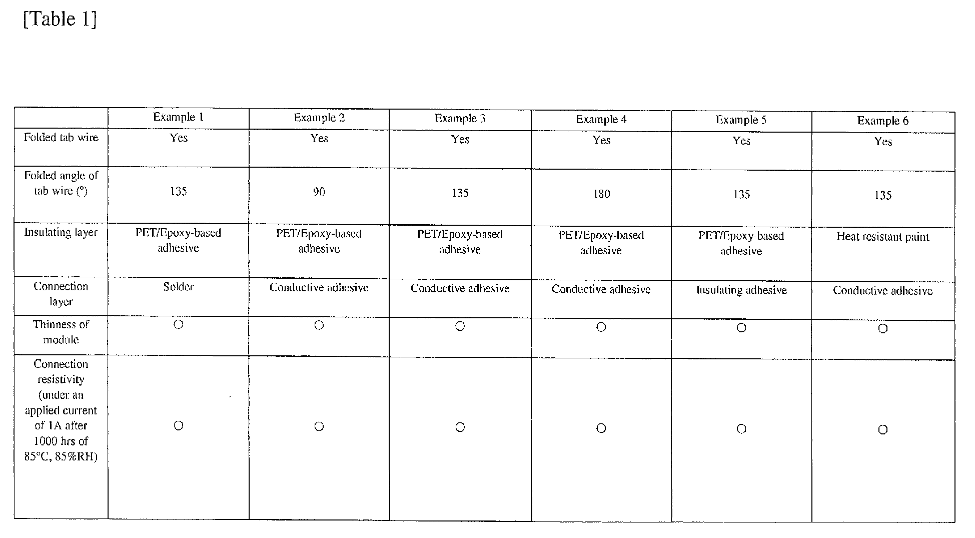

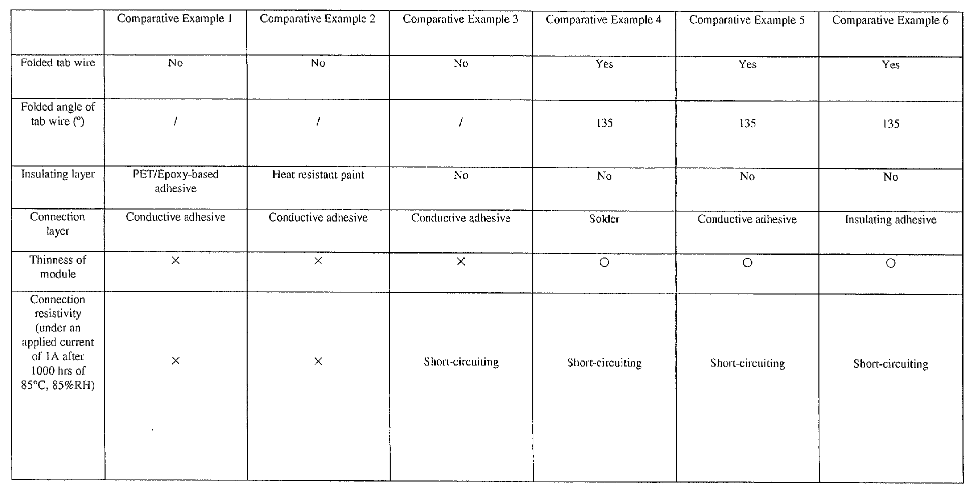

As shown in Table 1, with respect to the thinness of the module, since, in examples 1 to 6, only one tab wire was connected onto the electrode terminal unit without superposing the terminal box tab wire and the collector tab wire thereon, a thinner size was achieved. In contrast, in comparative examples 1 to 3, since the terminal box tab wire and the collector tab wire were superposed on the electrode terminal unit, it was not possible to achieve a thinner size of the module.

Moreover, with respect to the connection resistivity, since, in examples 1 to 6, the collector tab wire and the terminal box tab wire were continuously formed, no connection portion between the collector tab wire and the terminal box tab wire was present. Therefore, it was possible to prevent an increase of a resistance value caused by a concentrated charge onto the connection portion, degradation of the connection portion due to high temperature and high humidity environments, or an increase of a resistance value caused by degradation due to passing years. In contrast, in comparative examples 1 and 2, an increase in connection resistivity occurred due to degradation of the connection portion between the collector tab wire and the terminal box tab wire.

Moreover, in comparative examples 3 to 6, since no insulating layer was formed on the other surface of the terminal box tab wire, short circuits occurred in a gap to the rear-surface electrode film of the thin-film solar cell. Reference Signs List

1 ... thin-film solar cell, 2...solar cell, 3...sheet, 4...back sheet, 5 ... surfaces cover, 6...solar cell module, 7...metal frame, 8...translucent insulating substrate, 9...P-type electrode terminal unit, 10...N-type electrode terminal unit, 11...positive electrode tab wire, 11a...one surface, 12...positive electrode collector tab unit, 13...terminal box positive electrode tab unit, 14...folded part, 15...negative electrode tab wire, 15a...one surface, 16...negative electrode tab unit, 17...terminal box negative electrode tab unit, 18...folded part, 19...terminal box, 20...connection layer, 21...insulating layer, 22...conductive adhesion film, 23...binder resin layer, 24...conductive particles, 30...concavo-convex portion

## Claims

1. A solar cell module comprising:
a solar cell with an electrode disposed on one surface thereof;
a collector tab unit connected onto the electrode of the solar cell with a connection layer interposed therebetween;
a terminal box tab unit formed on the one surface the solar cell with an insulating layer interposed therebetween; and
a tab wire in which the collector tab unit and the terminal box tab unit are continuously formed via a folded part.

2. The solar cell module according to claim 1, wherein the tab wire is configured such that an excessive portion that is longer than the length of the electrode and protrudes from the electrode is folded.

3. The solar cell module according to claim 2, wherein the tab wire has a length about two times longer than the electrode, and is folded at a position of 50% of the overall length.

4. The solar cell module according to any one of claims 1 to 3, wherein the folded part has a folded angle in a range from 90° or more to 180° or less.

5. The solar cell module according to any one of claims 1 to 4, wherein the terminal box is secured in the center of the one surface, with one end of the terminal box tab unit being connected thereto.

6. The solar cell module according to claim 4, wherein, when the folded angle is 180°, the positive electrode terminal box and the negative electrode terminal box are disposed on the one surface.

7. The solar cell module according to any one of claims 1 to 6, wherein the connection layer is made of any material selected from the group consisting of solder, a conductive adhesive and an insulating adhesive.

8. The solar cell module according to claim 7, wherein the tab wire has a surface to be connected to the electrode prepared as a concavo-convex surface, which is connected to the electrode with an insulating connection layer interposed therebetween.

9. The solar cell module according to claim 7, wherein the conductive adhesive or the insulating adhesive is an epoxy-based adhesive.

10. The solar cell module according to any one of claims 1 to 9, wherein the tab wire is configured such that the conductive layer is formed over the entire surface of the one surface preliminarily connected to the electrode, with the insulating layer being formed over the entire surface of the surface on the opposite side to the one surface.

11. The solar cell module according to any one of claims 1 to 10, wherein the insulating layer is composed of an insulating film with an adhesive or a heat resistant paint.

12. A method for manufacturing a solar cell module comprising the steps of:
preparing a tab wire having a collector tab unit connected to an electrode of a solar cell and a terminal box tab unit formed on one surface of the solar cell;
connecting the collector tab unit to the electrode formed on the one surface of the solar cell, with a connection layer being interposed therebetween;
forming the terminal box tab unit on the one surface of the solar cell by folding one portion thereof from the collector tab unit, with an insulating layer interposed therebetween, and
connecting one end of the terminal box tab unit to a terminal box.

13. The method for manufacturing a solar cell module according to claim 12, wherein the tab wire has a length longer than the length of the electrode, with an excessive portion protruding from the electrode being folded.

14. The method for manufacturing a solar cell module according to claim 12 or 13, wherein the tab wire is configured such that the connection layer is formed over the entire surface of the one surface preliminarily connected to the electrode, with the insulating layer being formed over the entire surface of the surface on the opposite side to the one surface.

15. A tab wire for a thin-film solar cell module comprising:
a collector tab unit connected onto an electrode of a solar cell with a connection layer interposed therebetween, with the electrode being disposed on one surface of the solar cell; and
a terminal box tab unit formed on the one surface of the solar cell with an insulating layer interposed therebetween,
wherein the collector tab unit and the terminal box tab unit are continuously formed via a folded part.

16. The tab wire for a thin-film solar cell module according to claim 15, wherein the tab wire has a length longer than the length of the electrode, with an excessive portion protruding from the electrode being folded so as to form the terminal box tab unit.

17. The tab wire for a thin-film solar cell module according to claim 15 or 16, wherein the connection layer is formed over the entire surface of the one surface preliminarily connected to the electrode, with the insulating layer being formed over the entire surface of the surface on the opposite side to the one surface.
